## Europäisches Patentamt
## European Patent Office
## Office européen des brevets

(11) Veröffentlichungsnummer : **0 039 943**
**B1**

(12)

# EUROPÄISCHE PATENTSCHRIFT

(45) Veröffentlichungstag der Patentschrift :
22.06.83

(21) Anmeldenummer : 81103603.7

(22) Anmeldetag : 11.05.81

(51) Int. Cl.³ : **H 01 L 29/743**, H 01 L 29/08,
H 01 L 29/52

(54) Thyristor mit steuerbaren Emitterkurzschlüssen und Verfahren zu seinem Betrieb.

(30) Priorität : 14.05.80 DE 3018468

(43) Veröffentlichungstag der Anmeldung :
18.11.81 Patentblatt 81/46

(45) Bekanntmachung des Hinweises auf die Patenterteilung : 22.06.83 Patentblatt 83/25

(84) Benannte Vertragsstaaten :
CH FR GB IT LI NL SE

(56) Entgegenhaltungen :
EP A 0 028 798
DE A 2 133 430
DE B 2 163 922

(73) Patentinhaber : **SIEMENS AKTIENGESELLSCHAFT**
**Berlin und München Wittelsbacherplatz 2**
**D-8000 München 2 (DE)**

(72) Erfinder : **Patalong, Hubert, Dr.**
**Kurt-Flöricke-Strasse 18**
**D-8000 München 60 (DE)**·

Jouve, 18, rue St-Denis, 75001 Paris, France

Thyristor mit steuerbaren Emitterkurzschlüssen und Verfahren zu seinem Betrieb

Die Erfindung bezieht sich auf einen Thyristor mit steuerbaren Emitterkurzschlüssen nach dem Oberbegriff des Anspruchs 1 und auf ein Verfahren zu seinem Betrieb.

Thyristoren dieser Art sind in den deutschen Patentanmeldungen P 29 45 366.5 und P 29 45 324.5 beschrieben. Ferner sind sie Gegenstand der älteren europäischen Patentanmeldung EP-A-0 028 798 und gelten somit als Stand der Technik. Sind die steuerbaren Emitterkurzschlüsse als MIS-Strukturen des Verarmungstyps ausgebildet, so schließen sie ohne Zuführung einer Steuerspannung an ihre Gateelektroden jeweils einen Kurzschlußpfad, der den PN-Übergang zwischen der mit der Kathode (Anode) verbundenen Emitterschicht und der angrenzenden Basisschicht überbrückt. Damit weist der Thyristor eine gute Stabilität auf, d. h. eine große Sicherheit gegen unbeabsichtigte Zündvorgänge beim Auftreten von in Durchlaßrichtung gepolten Spannungen an der Anoden- Kathoden-Strecke, die teilweise sehr schnell ansteigen (hohe dU/dt-Belastung). Wird der Thyristor durch einen seiner Zündelektrode zugeführten Stromimpuls gezündet, so kann ein an der Zündelektrode abgreifbarer Zündspannungsimpuls an die Gateelektroden der steuerbaren Emitterkurzschlüsse gelegt werden, so daß diese für die Dauer der Zündung unwirksam geschaltet werden. Die Unwirksamschaltung stellt eine Einschaltmaßnahme dar und hat zur Folge, daß eine schnelle kontrollierte Zündung über dem gesamten Thyristorquerschnitt erfolgt. Falls andererseits steuerbare Emitterkurzschlüsse als MIS-Strukturen des Anreicherungstyps ausgebildet sind, so sind diese ohne Zuführung einer Steuerspannung an ihre Gateelektroden unwirksam und werden erst durch einen Steuerspannungsimpuls, der die entgegengesetzte Polarität zu dem genannten Zündspannungsimpuls aufweist, für die Dauer des Steuerspannungsimpulses wirksam geschaltet. Eine solche Steuerung erfolgt im stromführenden Zustand des Thyristors zu dem Zweck, eine schnelle Blokkierung desselben zu erreichen, stellt also eine Abschaltmaßnahme dar.

Der Erfindung liegt die Aufgabe zugrunde, einen mit steuerbaren Emitterkurzschlüssen versehenen Thyristor der eingangs genannten Art in seiner Struktur wesentlich zu vereinfachen. Diese Aufgabe wird durch die im Anspruch 1 angeführten Merkmale gelöst.

Der mit der Erfindung erzielbare Vorteil besteht insbesondere darin, daß die Zündelektrode und die Gateelektroden der steuerbaren Emitterkurzschlüsse aus ein und derselben leitenden Belegung bestehen, deren Randzonen gegenüber der Grenzfläche des Halbleiterkörpers isoliert sind, während ein anderer Teil der Belegung die Grenzfläche kontaktiert. Die leitende Belegung ist mit einem Anschluß versehen, der sowohl den Anschluß für die Zündelektrode darstellt als auch den Steuerspannungsanschluß für die Gateelektroden der MIS-Strukturen.

Die Ansprüche 2 bis 8 sind auf bevorzugte Ausgestaltungen und Weiterbildungen der Erfindung gerichtet. Der Anspruch 9 gibt ein vorteilhaftes Verfahren zum Betrieb eines erfindungsgemäßen Thyristors an.

Die Erfindung wird nachfolgend anhand der Zeichnung näher erläutert. Dabei zeigt :

Figur 1 ein erstes Ausführungsbeispiel der Erfindung,

Figur 2 ein zweites Ausführungsbeispiel,

Figur 3 ein drittes Ausführungsbeispiel und

Figur 4 eine Draufsicht auf das Ausführungsbeispiel nach Figur 3.

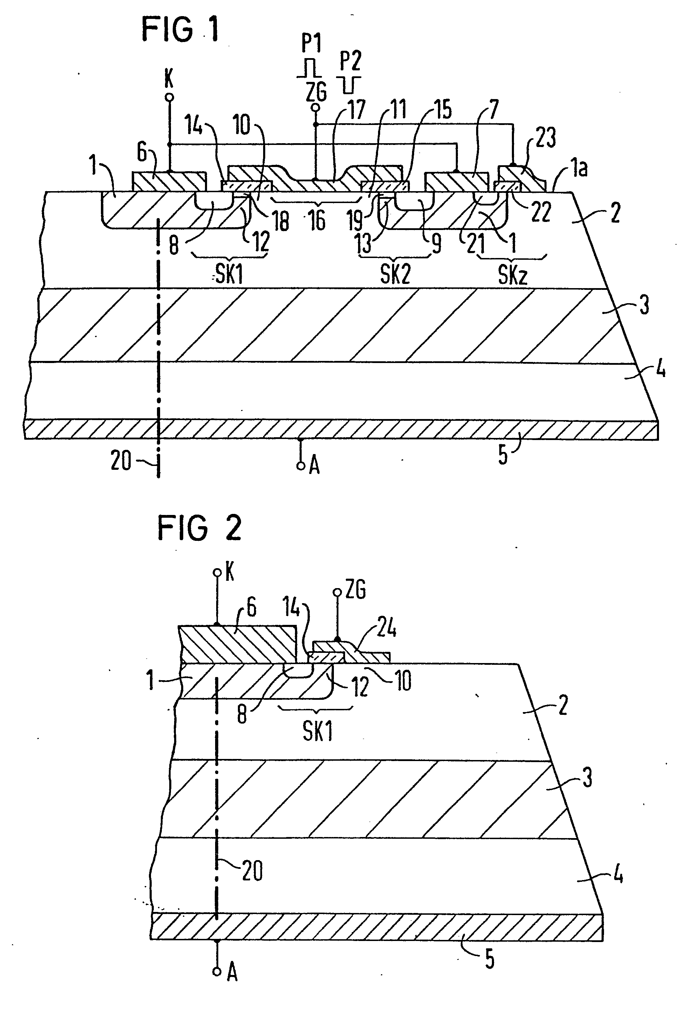

Der in Figur 1 im Querschnitt dargestellte Thyristor weist einen Halbleiterkörper mit aneinandergrenzenden Schichten 1 bis 4 abwechselnder Leitfähigkeitstypen auf, die beispielsweise aus dotiertem Silizium bestehen. Dabei werden die außenliegende N-leitende Schicht 1 als N-Emitterschicht und die außenliegende P-leitende Schicht 4 als P-Emitterschicht bezeichnet. An diese grenzen jeweils die sogenannten Basisschichten an, und zwar die P-Basisschicht 2 an die N-Emitterschicht 1 und die N-Basisschicht 3 an die P-Emitterschicht 4. Die P-Emitterschicht 4 ist mit einer Anode 5 versehen, die einen Anodenanschluß A besitzt, während die N-Emitterschicht 1 in zwei lateral nebeneinanderliegende N-Emitterzonen aufgeteilt ist. Jede dieser Emitterzonen ist mit einem Teil 6, 7 einer Kathode versehen, wobei die einzelnen Teile der Kathode untereinander leitend verbunden und an einen gemeinsamen Kathodenanschluß K geführt sind.

In die N-Emitterzone 1 sind P-leitende Halbleitergebiete 8 und 9 so eingefügt, daß sie sich bis zur Grenzfläche 1a des Halbleiterkörpers erstrecken und in dieser randseitig von den Teilen 6, 7 der Kathode kontaktiert werden. Mit 10 und 11 sind einzelne Zonen der P-Basisschicht 2 bezeichnet, die von der Grenzfläche 1a ausgehen und an diejenigen Teile der N-Emitterzonen, die die Halbleitergebiete 8 bzw. 9 enthalten, lateral angrenzen. Der Teil 12 der linken N-Emitterzone 1 stellt eine N-Zwischenschicht dar, die das P-leitende Halbleitergebiet 8 und die P-leitende Zone 10 voneinander trennt. In analoger Weise bildet der Teil 13 der rechten N-Emitterzone 1 eine N-Zwischenschicht zwischen den Teilen 9 und 11. Auf der Grenzfläche 1a sind dünne, elektrisch isolierende Schichten 14 und 15 vorgesehen, beispielsweise aus $SiO_2$, die zwischen sich einen Bereich 16 der Grenzfläche 1a freilassen. Eine elektrisch leitende Belegung 17, die beispielsweise aus Metall oder aus stark dotiertem polykristallinem Silizium besteht, ist nun so angeordnet, daß sie mit ihren Randzonen die isolierenden Schichten 14 und 15 und damit auch die N-Zwischenschichten 12, 13 überdeckt, und mit einer mittleren Zone die P-Basisschicht 2 innerhalb des Bereiches 16 der Grenzfläche 1a kontaktiert. Die leitende Belegung 17 weist einen Anschluß auf, der mit ZG bezeichnet ist.

Die Teile 8, 10, 12, 14 bilden zusammen mit der linken Randzone der leitenden Belegung 17 eine erste MIS-Struktur, die Teile 9, 11, 13, 15 zusammen mit der rechten Randzone der Belegung 17 eine zweite MIS-Struktur. Die Randzonen der Belegung 17 stellen dabei die Gateelektroden dieser Strukturen dar, der mittlere, die P-Basisschicht 2 kontaktierende Teil der Belegung die Zündelektrode des Thyristors. Gehören die MIS-Strukturen dem Verarmungstyp an, so befinden sich ohne Einwirkung einer Spannung auf die Belegung 17 P-leitende Inversionskanäle 18, 19 an der Grenzfläche 1a, die jeweils die Zone 10 mit dem Halbleitergebiet 8 und die Zone 11 mit dem Halbleitergebiet 9 leitend verbinden. Legt man eine in Bezug auf den Kathodenanschluß K positive Steuerspannung hinreichender Größe an den Anschluß ZG, so werden die Inversionskanäle 18, 19 beseitigt. Sind die MIS-Strukturen vom Anreicherungstyp, so bestehen ohne Zuführung einer Spannung an den Anschluß ZG keine Inversionskanäle 15, 16. Diese werden dann erst durch das Anlegen einer die Einsatzspannung übersteigenden, in Bezug auf den Kathodenanschluß K negativen Spannung an ZG aufgebaut.

Der P-leitende Inversionskanal 18 stellt also die Schaltstrecke eines steuerbaren Kurzschlusses SK1 dar, der in Abhängigkeit von einer dem Anschluß ZG zugeführten Steuerspannung die P-Basisschicht 2 mit dem Gebiet 8 und damit mit dem Teil 6 der Kathode niederohmig verbindet oder nicht. In gleicher Weise bildet der Inversionskanal 19 die Schaltstrecke eines steuerbaren Emitterkurzschlusses SK2, der in Abhängigkeit von einer dem Anschluß ZG zugeführten Steuerspannung die P-Basisschicht 2 mit dem Teil 7 der Kathode wahlweise leitend verbindet.

In einer ersten Ausgestaltung der Erfindung sind die Emitterkurzschlüsse SK1 und SK2 nur für die Dauer des Zündvorgangs unwirksam geschaltet und vor und nach demselben stets wirksam. Dabei können die MIS-Strukturen 8, 10, 12, 14, 17 und 9, 11, 13, 15, 17 mit Vorteil dem Verarmungstyp angehören. Die Kurzschlüsse SK1 und SK2 sind dann ohne Zuführung einer Spannung an den Anschluß ZG zunächst wirksam und stabilisieren den Thyristor gegenüber hohen dU/dt-Belastungen, die im blockierten Zustand auftreten. Durch Zuführung eines positiven Zündimpulses P1 an den Anschluß ZG zündet der Thyristor, wobei gleichzeitig während der Dauer von P1 die Emitterkurzschlüsse SK1 und SK2 unwirksam geschaltet werden, so daß sich die jeweils gezündete Fläche in lateraler Richtung rasch über den gesamten Querschnitt des Thyristors ausbreitet. Im gezündeten Zustand fließt dann ein Laststrom eines an A und K angeschlossenen Lastkreises über den niederohmig geschalteten Thyristor. Die Abschaltung desselben wird durch eine Abschaltung der zwischen A und K in Durchlaßrichtung anliegenden Spannung erreicht, oder, falls es sich bei ihr um eine Wechselspannung handelt, durch den nächstfolgenden Nulldurchgang.

Für einige Anwendungsfälle kann es erwünscht sein, im Rahmen der ersten Ausgestaltung MIS-Strukturen des Anreicherungstyps zu verwenden. Hierbei liegt dann der Anschluß ZG im blockierten Zustand des Thyristors an einer negativen Vorspannung, unter deren Einfluß die Inversionskanäle 18, 19 aufgebaut werden. Zum Zeitpunkt der Zündung wird dann die negative Vorspannung von ZG abgeschaltet und ein positiver Zündimpuls P1 zugeführt. Es besteht auch die Möglichkeit, die negative Vorspannung angeschaltet zu lassen und ihr einen hinreichend großen Zündimpuls P1 zu überlagern. In jedem dieser Fälle werden die Inversionskanäle 18, 19 während des Zündvorgangs unterbrochen.

Nach einer zweiten Ausgestaltung der Erfindung sind die Emitterkurzschlüsse SK1 und SK2 nur beim Abschalten des Thyristors — wodurch dieser aus dem stromführenden Zustand in den blockierten Zustand gelangt, ohne daß die in Durchlaßrichtung anliegende Spannung an den Anschlüssen A und K abgeschaltet wird — wirksam geschaltet und vor bzw. nach diesem Abschaltvorgang stets unwirksam. Sind die MIS-Strukturen vom Anreicherungstyp, so wird hierbei durch den positiven Zündimpuls P1 zwar die Zündung bewirkt, jedoch die Sperrung der Emitterkurzschlüsse SK1 und SK2 nicht aufgehoben. Erst wenn dem Anschluß ZG ein negativer Impuls P2 zugeführt wird, erfolgt die Abschaltung des Thyristors durch die Wirksamschaltung von SK1 und SK2.

Bei einer dritten Ausgestaltung der Erfindung ist vorgesehen, daß die eine MIS-Struktur, z. B. die Struktur 8, 10, 12, 14, 17, den Verarmungstyp und die andere MIS-Struktur, z. B. die Struktur 9, 11, 13, 15, 17, dem Anreicherungstyp angehört. Hierbei ist dann der Emitterkurzschluß SK1 nur beim Auftreten des positiven Zündimpulses P1, d. h. während des Zündvorgangs, unwirksam geschaltet und vor bzw. nach demselben stets wirksam, während SK2 nur beim Anlegen eines negativen Impulses P2, d. h. während des Abschaltens des Thyristors, wirksam geschaltet ist und im übrigen stets unwirksam ist. In diesem Fall dient SK1 als eine Einschalthilfe, während SK2 eine Abschalthilfe darstellt.

In Figur 1 kann nach einer Weiterbildung auch am rechten Rand der rechten Emitterzone 1 ein P-leitendes Halbleitergebiet 21 vorgesehen sein. Zusammen mit einer dünnen, elektrisch isolierenden Schicht 22 und einer leitenden Belegung 23, die mit ihrem linken Teil eine mit ZG verbundene Gateelektrode bildet, stellt es einen zusätzlichen steuerbaren Emitterkurzschluß SKz dar, der nach der ersten und zweiten Ausgestaltung jeweils so ausgebildet ist und betrieben wird wie SK1 und SK2. Bei der dritten Ausgestaltung gehört die MIS-Struktur 21, 22, 23 mit Vorteil dem Verarmungstyp an, so daß SKz nur während des Abschaltens des Thyristors wirksam geschaltet ist. Der rechte Teil der leitenden Belegung 23 kontaktiert die P-Basisschicht 2 und stellt einen weiteren Teil der Zündelektrode dar.

Die N-Emitterzonen 1 können in Figur 1 langgestreckt ausgebildet sein, so daß sie senkrecht zur Bildebene wesentlich größere Abmessungen aufweisen als in derselben. Sie verlaufen dann zweckmäßigerweise geradlinig und parallel zueinander über die ganze Grenzfläche 1a des im allgemeinen als runde Scheibe ausgebildeten Thyristors. Dabei kann die Linie 20 als eine Symmetrieebene aufgefaßt werden, die senkrecht zur Bildebene liegt. Der Kathodenteil der linksseitig von der Linie 20 vorgesehenen N-Emitterzone ist dann ebenfalls an den Anschluß K geführt, während die zugeordneten leitenden Belegungen mit dem Anschluß ZG verbunden sind. Andererseits kann der Thyristor nach Figur 1 auch rotationssymmetrisch aufgebaut sein, wobei die Linie 20 die Symmetrieachse darstellt. In diesem Fall weisen der Teil 6 der Kathode und die linke Emitterzone 1 jeweils einen kreisförmigen Umriß auf, während die Teile 7, 17 und 23 sowie die rechte Emitterzone 1 ringförmig ausgebildet sind.

Figur 2 zeigt ein gegenüber Figur 1 vereinfachtes Ausführungsbeispiel, bei dem die N-Emitterschicht nur aus einer Emitterzone 1 besteht. Die Teile 8, 10, 12 und 14 bilden zusammen mit einer leitenden Belegung 24, deren linker Teil die isolierende Schicht 14 und die N-Zwischenschicht 12 überdeckt, den Emitterkurzschluß SK1. Der rechte Teil der Belegung 24 kontaktiert die P-Basisschicht 2 und bildet die Zündelektrode. Der Anschluß von 24 ist entsprechend Figur 1 mit ZG bezeichnet. Die Teile 1, 6 und 24 können wieder langgestreckt ausgebildet sein, und zwar derart, daß sie senkrecht zur Bildebene von Figur 2 wesentlich größere Abmessungen aufweisen als in derselben. Dabei kann die Linie 20 wieder als eine senkrecht zur Bildebene stehende Symmetrieebene aufgefaßt werden, wobei dann die dem Teil 24 entsprechende, links von der Linie 20 liegende leitende Belegung mit dem Anschluß ZG verbunden ist. Andererseits ist auch ein rotationssymmetrischer Aufbau des Thyristors nach Figur 2 mit der Linie 20 als Symmetrieachse zweckmäßig. SK1 kann entweder während des Einschaltvorgangs unwirksam geschaltet oder während des Ausschaltvorgangs wirksam geschaltet werden. Mit 20 als Symmetrieebene kann der links von ihr liegende, steuerbare Emitterkurzschluß dem Anreicherungstyp angehören, der rechts von ihr liegende dem Verarmungstyp.

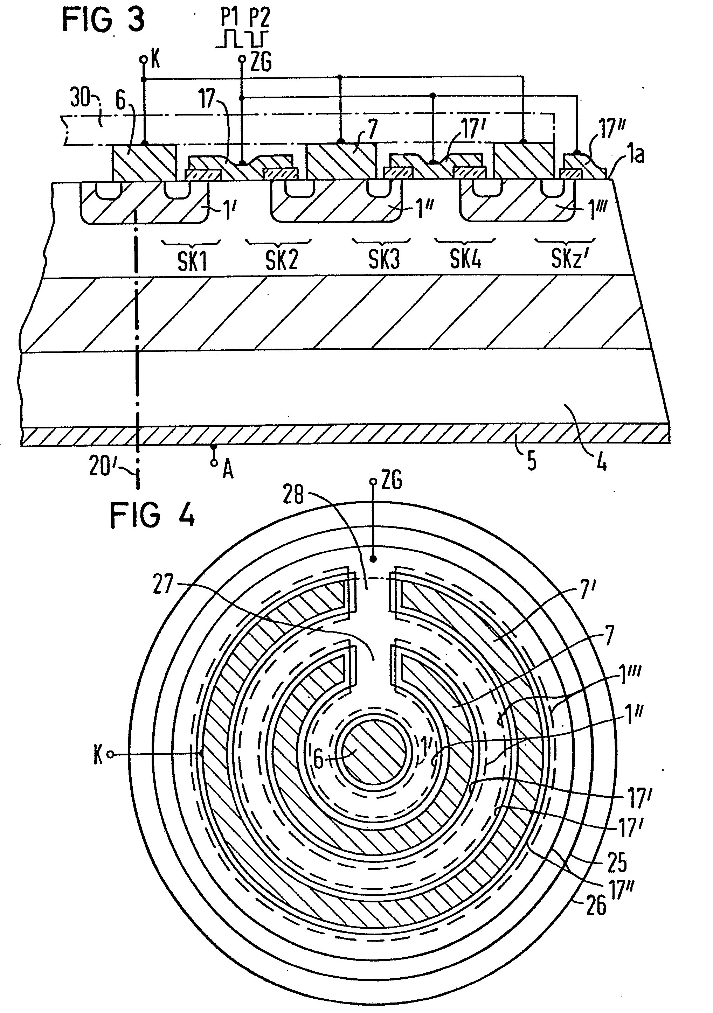

Das in Figur 3 dargestellte Ausführungsbeispiel unterscheidet sich von Figur 1 dadurch, daß drei N-Emitterzonen 1′ bis 1‴ dargestellt sind, wobei die Zone 1‴ mit einem Teil 7′ der Kathode belegt ist, der mit dem Anschluß K verbunden ist. Randseitig zu den N-Emitterzonen 1″ und 1‴ ist eine leitende Belegung 17′ angeordnet, deren gegenüber der Grenzfläche 1a isolierte Randzonen die Gateelektroden für zwei weitere steuerbare Emitterkurzschlüsse SK3 und SK4 bilden, während ihre mittlere Zone einen weiteren Teil der Zündelektrode darstellt. Die Belegung 17′ ist mit der Belegung 17 und damit auch mit dem Anschluß ZG verbunden. Auch hier können die N-Emitterzonen 1′ bis 1‴ entweder langgestreckt ausgebildet sein, wobei die Linie 20′ als eine Symmetrieebene aufzufassen ist, oder es ist ein rotationssymmetrischer Aufbau des Thyristors vorgesehen, wobei die Linie 20′ als Symmetrieachse zu denken ist.

Die einzelnen Emitterkurzschlüsse SK1 bis SK4 können wieder so ausgebildet werden, daß sie entweder während des Zündvorgangs unwirksam geschaltet sind und im übrigen wirksam sind oder daß sie lediglich während des Ausschaltens wirksam sind und im übrigen unwirksam geschaltet sind. Teilt man die Emitterkurzschlüsse auf in eine erste Gruppe von nur während des Zündvorgangs unwirksam geschalteten und in eine zweite Gruppe von nur während des Abschaltens wirksam geschalteten, so ist es zweckmäßig, die zweite Gruppe größer zu machen als die erste. So können beispielsweise die Emitterkurzschlüsse SK2 bis SK4 der zweiten Gruppe angehören, während der Kurzschluß SK1 der ersten Gruppe zugeordnet ist. Ein weiterer steuerbarer Emitterkurzschluß SKz′, der entsprechend SKz in Figur 1 aufgebaut ist, kann mittels einer leitenden Belegung 17″ an der rechten Seite der Emitterzone 1‴ vorgesehen sein. Bei einer Aufteilung der in Figur 3 vorhandenen Emitterkurzschlüsse in die beiden genannten Gruppen wird SKz′ zum Beispiel der zweiten Gruppe zugeordnet.

Figur 4 zeigt eine Draufsicht auf einen gemäß Figur 3 ausgebildeten Thyristor mit rotationssymmetrischem Aufbau. Dabei sind die lateralen Begrenzungen der einzelnen N-Emitterzonen 1′, 1″ und 1‴ gestrichelt dargestellt, soweit sie sich unter den leitenden Belegungen 17, 17′ und 17″ befinden. Die Teile 6, 7 und 7′ der Kathode sind zur Verdeutlichung schraffiert dargestellt. Der äußere Rand der oberen Begrenzungsfläche des Thyristors ist mit 25 angedeutet, der äußere Rand der P-Emitterschicht 4 mit 26. Die kreisringförmigen Belegungen 17 und 17′ sind durch ein Verbindungsteil 27 miteinander verbunden, die Belegungen 17′ und 17″ durch ein Verbindungsteil 28, wobei die Belegung 17″ mit dem Anschluß ZG versehen ist. Die Kathodenteile 6, 7 und 7′ werden zweckmäßigerweise durch eine Kathodenplatte 30 (Figur 3) kontaktiert, wobei der Kathodenanschluß K an der Kathodenplatte angebracht ist.

Anstelle der N-Emitterschicht 1 kann auch die P-Emitterschicht 4 in einzelne Zonen aufgeteilt sein, die mit einzelnen, untereinander verbundenen Teilen der Anode belegt sind. Hierbei sind steuerbare P-Emitterkurzschlüsse vorgesehen. Die Figuren 1 bis 3 können zur Darstellung dieser Variante herangezogen werden, wenn die Bezeichnungen der Anschlüsse A und K miteinander vertauscht werden und die Halbleiterteile 1 bis 4, 8, 9 und 21 jeweils die entgegengesetzten Leitfähigkeiten zu den bisher beschriebenen aufweisen. Der Impuls P1 hat dann ein negatives Vorzeichen, der Impuls P2 ein positives.

**Ansprüche**

1. Thyristor mit einem Halbleiterkörper, der eine außenliegende, mit einer Kathode bzw. Anode (6, 7) versehene N-Emitterschicht bzw. P-Emitterschicht (1), eine außenliegende, mit einer Anode bzw. Kathode (5) versehene P-Emitterschicht bzw. N-Emitterschicht (4) und zwei an diese jeweils angrenzende Basisschichten (2, 3) enthält, mit wenigstens einem randseitig zu der N-Emitterschicht bzw. P-Emitterschicht angeordneten, als MIS-Struktur (8, 10, 12, 14, 17) ausgebildeten Emitterkurzschluß, bestehend aus einem in die N-Emitterschicht bzw. P-Emitterschicht eingefügten, zu dieser entgegengesetzt dotierten Halbleitergebiet (8, 9), das sich bis zur Grenzfläche des Halbleiterkörpers erstreckt und in dieser mit der Kathode bzw. Anode (8, 9) leitend verbunden ist, aus einer Zone (10) der an die betreffende Emitterschicht angrenzenden Basisschicht und aus einer Zwischenschicht, welche durch einen Teil der betreffenden Emitterschicht (1) gebildet und von einer isoliert auf der Grenzfläche aufgebrachten Gateelektrode (17) überdeckt wird, und mit einer auf einer Basisschicht (2) aufgebrachten Zündelektrode (17), dadurch gekennzeichnet, daß auf der die N-Emitterschicht bzw. P-Emitterschicht (1) enthaltenden Grenzfläche (1a) des Halbleiterkörpers wenigstens eine mit einem Anschluß (ZG) versehene, elektrisch leitende Belegung (17) aufgebracht ist, deren gegenüber der Grenzfläche (1a) isolierte Seitenzone die Gateelektrode der MIS-Struktur (8, 10, 12, 14, 17) darstellt, während eine die Grenzfläche (1a) kontaktierende Zone dieser Belegung (17) die Zündelektrode bildet.

2. Thyristor nach Anspruch 1, dadurch gekennzeichnet, daß die N-Emitterschicht bzw. P-Emitterschicht (1) in zwei oder mehrere mit Teilen (6, 7, 7') der Kathode versehene Emitterzonen (1, 1', 1'', 1''') aufgeteilt ist und daß randseitig zu den Emitterzonen eine oder mehrere leitende Belegungen (17, 17') aufgebracht sind, deren gegenüber der Grenzfläche (1a) isolierte Seitenzonen die Gateelektroden der zugeordneten MIS-Strukturen (8, 10, 12, 14, 17 ; 9, 11, 13, 15, 17) darstellen, während ihre die Grenzfläche (1a) kontaktierenden Mittelzonen die Zündelektrode oder Teile derselben bilden.

3. Thyristor nach Anspruch 1 oder 2, dadurch gekennzeichnet, daß die MIS-Strukturen (8, 10, 12, 14, 17 ; 9, 11, 13, 15, 17) dem Verarmungstyp angehören.

4. Thyristor nach Anspruch 1 oder 2, dadurch gekennzeichnet, daß die MIS-Strukturen (8, 10, 12, 14, 17 ; 9, 11, 13, 15, 17) dem Anreicherungstyp angehören.

5. Thyristor nach Anspruch 1 oder 2, dadurch gekennzeichnet, daß ein Teil der MIS-Strukturen (8, 10, 12, 14, 17) dem Verarmungstyp und der übrige Teil (9, 11, 13, 15, 17) dem Anreicherungstyp angehört.

6. Thyristor nach einem der Ansprüche 1 bis 5, dadurch gekennzeichnet, daß die Emitterschicht oder die Emitterzonen (1) langgestreckt ausgebildet sind und etwa parallel zueinander über die ganze Thyristorfläche verlaufen.

7. Thyristor nach einem der Ansprüche 2 bis 5, dadurch gekennzeichnet, daß die Emitterzonen (1) in der Form von Kreisringen ausgebildet sind und konzentrisch zueinander und zu der kreisförmig ausgebildeten innersten Emitterzone (1) angeordnet sind.

8. Thyristor nach Anspruch 7, dadurch gekennzeichnet, daß die leitenden Belegungen (17, 17') ebenfalls kreisringförmig ausgebildet und durch radiale Verbindungsteile (27, 28) miteinander verbunden sind und daß die Emitterzonen (1'', 1''') im Bereich dieser Verbindungsteile (27, 28) jeweils unterbrochen sind.

9. Thyristor nach einem der Ansprüche 2 bis 8, dadurch gekennzeichnet, daß die Teile (6, 7, 7') der Kathode durch eine Kathodenplatte (30) kontaktiert sind, an der der Kathodenanschluß angebracht ist.

10. Verfahren zum Betrieb eines Thyristors nach Anspruch 1 und 5, dadurch gekennzeichnet, daß dem Anschluß der leitenden Belegung bzw. Belegungen (17, 17') zum Zwecke der Zündung ein Zündimpuls (P1) einer ersten Polarität und zum Zwecke der Umschaltung des Thyristors aus dem stromführenden Zustand in den blockierten Zustand ein Impuls (P2) entgegengesetzter Polarität zugeführt werden.

**Claims**

1. A thyristor comprising a semiconductor body which contains an N-emitter layer or P-emitter layer (1), which is arranged on the outside and which is provided with a cathode or anode (6, 7) as the case may be, a P-emitter layer or N-emitter layer (4) which is arranged on the outside and which is provided with an anode or cathode (5) as the case may be, and base layers (2, 3) which respectively adjoin the emitter layers, and comprising at least one emitter short circuit which is in the form of an MIS-structure (8, 10, 12, 14, 17), which is arranged at the edge of the N- or P-emitter layer (1) and which consists of a semiconductor region (8, 9) which is inserted into N- or P-emitter layer (1) and is oppositely doped thereto, and which extends to the boundary surface of the semiconductor body and, at this boundary surface, is conductively connected to the cathode or anode (8, 9), of a zone (10) of the base layer adjoining the emitter layer in question, and of an intermediate layer which is formed by a part of the emitter layer (1) in question and is covered by a gate electrode (17) which is applied on the boundary surface in insulating manner, and comprising an ignition electrode (17) which is applied on a base layer (2), characterised in that at least one electrically-conductive coating (17) provided with a terminal (ZG) is applied on the boundary surface (1a) of the semiconductor body, which contains the N- or P-emitter layer (1), the lateral zone of which coating which is insulated from the boundary surface (1a) representing the gate electrode of the MIS-structure (8, 10, 12, 14, 17), whilst a zone of this coating (17) which is in contact with the boundary surface (1a) forms the ignition electrode.

2. A thyristor as claimed in Claim 1, characterised in that the N- or P-emitter layer (1) is divided into two or more emitter zones (1, 1', 1″, 1‴) which are provided with parts (6, 7, 7') of the cathode, and that at the edge of the emitter zones, there are applied one or more conductive coatings (17, 17'), the lateral zones of which are insulated from the boundary surface (1a) and represent the gate electrodes of the assigned MIS-structures (8, 10, 12, 14, 17 ; 9, 11, 13, 15, 17), whilst their central zones which are in contact with the boundary surface (1a) form the ignition electrode or parts thereof.

3. A thyristor as claimed in Claim 1 or Claim 2, characterised in that the MIS-structures (8, 10, 12, 14, 17 ; 9, 11, 13, 15, 17) are of the depletion type.

4. A thyristor as claimed in Claim 1 or Claim 2, characterised in that the MIS structures (8, 10, 12, 14, 17 ; 9, 11, 13, 15, 17) are of the enhancement type.

5. A thyristor as claimed in Claim 1 or Claim 2, characterised in that a part of the MIS-structures (8, 10, 12, 14, 17) is of the depletion type and the other part (9, 11, 13, 15, 17) is of the enhancement type.

6. A thyristor as claimed in one of Claims 1 to 5, characterised in that the emitter layer or the emitter zones (1) are of elongate form and run approximately parallel to one another across the entire surface of the thyristor.

7. A thyristor as claimed in one of Claims 2 to 5, characterised in that the emitter zones (1) are annular in shape and are arranged concentrically to one another and to the innermost emitter zone (1) which is circular in shape.

8. A thyristor as claimed in Claim 7, characterised in that the conductive coatings (17, 17') are also annular and are connected to one another by radial connecting elements (27, 28) ; and that the emitter zones (1″, 1‴) are respectively interrupted in the region of these connection elements (27, 28).

9. A thyristor as claimed in one of Claims 2 to 8, characterised in that the parts (6, 7, 7') of the cathode are contacted by means of a cathode plate (30) to which the cathode terminal is fastened.

10. A process for the operation of a thyristor as claimed in Claim 1 and 5, characterised in that the terminal of the conductive coating or coatings (17, 17') is fed with an ignition pulse (P1) of a first polarity for the purpose of ignition and with a pulse (P2) of the opposite polarity for the purpose of changing over the thyristor from the current-carrying to the blocked state.

## Revendications

1. Thyristor à corps semiconducteur, comportant une couche d'émetteur du type N ou une couche d'émetteur du type P (1) située à l'extérieur et pourvue d'une cathode ou d'une anode (6, 7), une couche d'émetteur du type P ou une couche d'émetteur du type N (4) pourvue d'une anode ou d'une cathode (5), à au moins un court-circuit d'émetteur disposé sur le bord par rapport à la couche d'émetteur du type N ou à la couche d'émetteur du type P et réalisé sous la forme d'une structure MIS, constitué par une zone semiconductrice (8, 9) insérée dans la couche d'émetteur du type N ou dans la couche d'émetteur du type P, laquelle zone est dopée en sens opposé au dopage de ladite couche d'émetteur et s'étend jusqu'à la surface limite du corps semiconducteur dans laquelle elle est reliée avec la cathode ou l'anode (8, 9), par une zone (10) de la couche de base qui avoisine la couche d'émetteur concernée et par une couche intermédiaire qui est formée par une partie de la couche d'émetteur (1) concernée et qui est recouverte par une électrode de grille (17) disposée avec isolation sur la surface limite, et avec une électrode d'amorçage (17) disposée sur une couche de base (2), caractérisé par le fait que sur la surface limite (1a) du corps semiconducteur, dans laquelle est contenue la couche d'émetteur du type N ou la couche émetteur du type P (1), est déposé au moins un revêtement (17) électriquement conducteur, pourvu d'une borne de branchement (ZG) et dont la zone latérale, isolée par rapport à surface limite (1a), représente l'électrode de grille à structure MIS (8, 10, 12, 14, 17), alors qu'une zone de ce revêtement (17), qui contacte la surface limite (1a), forme l'électrode d'amorçage.

2. Thyristor selon la revendication 1, caractérisé par le fait que la couche d'émetteur N ou la couche d'émetteur P (1) est subdivisée en deux ou plusieurs zones d'émetteur (1, 1', 1″, 1‴) pourvues de parties (6, 7, 7') de la cathode, et que du côté du bord des zones d'émetteur sont déposés un ou plusieurs revêtements conducteurs (17, 17') dont les zones latérales, isolées par rapport à la surface limite (1a), représentent les électrodes de grille des structures MIS associées (8, 10, 12, 14, 17 ; 9, 11, 13, 15, 17), alors que leurs zones médianes qui contactent la surface limite (1a) constituent l'électrode d'amorçage ou des parties de celle-ci.

3. Thyristor selon la revendication 1 ou 2, caractérisé par le fait que les structures MIS (8, 10, 12, 14, 17 ; 9, 11, 13, 15, 17) appartiennent au type à appauvrissement.

4. Thyristor selon la revendication 1 ou 2, caractérisé par le fait que les structures MIS (8, 10, 12, 14, 17 ; 9, 11, 13, 15, 17) appartiennent au type à enrichissement.

5. Thyristor selon la revendication 1 ou 2, caractérisé par le fait qu'une partie des structures MIS (8, 10, 12, 14, 17) appartient au type à appauvrissement et l'autre partie (9, 11, 13, 15, 17) au type à enrichissement.

6. Thyristor selon l'une des revendications 1 à 5, caractérisé par le fait que la couche d'émetteur ou les zones d'émetteur (1) sont réalisées de façon allongée et s'étendent à peu près parallèlement entre elles sur toute la surface du thyristor.

7. Thyristor selon l'une des revendications 2 à 5, caractérisé par le fait que les zones d'émetteur (1) sont réalisées sous la forme d'anneaux circulaires et sont disposées concentriquement entre elles et par rapport à la zone d'émetteur la plus intérieure (1), ayant la forme d'un cercle.

8. Thyristor selon la revendication 7, caractérisé par le fait que les revêtements conducteurs (17, 17') sont également réalisés à la forme d'anneaux circulaires et sont reliés entre eux par des éléments de liaison radiaux (27, 28), et que les zones d'émetteur (1", 1''') sont respectivement interrompues au niveau de ces parties de liaison (27, 28).

9. Thyristor selon l'une des revendications 2 à 8, caractérisé par le fait que les parties (6, 7, 7') de la cathode sont contactées par une plaque de cathode (30) sur laquelle est montée la borne de cathode.

10. Procédé pour la mise en œuvre d'un thyristor selon les revendications 1 et 5, caractérisé par le fait que l'on applique à la borne du ou des revêtements conducteurs (17, 17'), dans le but de l'amorçage d'une impulsion d'amorçage (P1) d'une première polarité et, dans le but de commuter le transistor de son état passant à son état bloqué, une impulsion (P2) de polarité opposée.

FIG 1

FIG 2

FIG 3

FIG 4